Europäisches Patentamt

European Patent Office

Office européen des brevets

(11) Publication number: **0 243 566**
**A2**

# EUROPEAN PATENT APPLICATION

(21) Application number: **86810604.8**

(22) Date of filing: **19.12.86**

(51) Int. Cl.⁴: **G01D 5/16**

(30) Priority: **28.12.85 JP 299416/85**

(43) Date of publication of application:
**04.11.87 Bulletin 87/45**

(84) Designated Contracting States:
**CH DE FR GB LI NL**

(71) Applicant: **Nippon Gakki Seizo Kabushiki Kaisha**
**10-1, Nakazawa-cho**
**Hamamatsu-shi Shizuoka-ken(JP)**

(72) Inventor: **Iijima, Kenzaburou**
**C/o Nippon Gakki Seizo K.K.**
**Shizuoka-Ken(JP)**
Inventor: **Hayashi, Yoshinori**
**C/o Nippon Gakki Seizo K.K.**
**Shizuoka-Ken(JP)**

(74) Representative: **Nithardt, Roland**
**CABINET ROLAND NITHARDT Rue Edouard Verdan 15**
**CH-1400 Yverdon(CH)**

(54) An improved magnetic resistor-type sensor for encoders.

(57) In construction of a magnetic resistor-type sensor including magnetic resistor elements which change resistances thereof in response to periodical change of magnetic field applied to by a scale to be detected, use of a bridge circuit driven by constant voltage assures high level of output and easy later stage signal processing.

# Fig. 2

EP 0 243 566 A2

## AN IMPROVED MAGNETIC RESISTOR-TYPE SENSOR FOR ENCODERS

### Background of the present invention

The present invention relates to an improved magnetic resistor-type sensor for encoders, and more particularly relates to an improvement in construction of a magnetic resistor-type sensor including magnetic resistor elements which change resistances thereof in response to periodical change of magnetic field applied to by a scale to be detected.

The operation of the magnetic resistor-type sensor of the above-described type is based upon the principle of magnetic resistance effect in which the inherent resistance of a magnetic resistor element changes under influence by applied magnetic field. For example, Fe-Ni base alloy is deposited on a glass substrate to form such a magnetic resistor element.

In one typical conventional example, such a magnetic resistor-type sensor is used in combination with a scale provided with a magnetized pattern periodically formed in the direction of its displacement. The magnetic resistor-type sensor includes a pair of magnetic resistor elements arranged in the influential area of the periodically changing magnetic field generated by the magnetized pattern on the scale in a manner such that their output signals should have a phase-lag of 90 degrees. In the circuit of such a magnetic resistor-type sensor, each magnetic resistor element A under influence of the magnetic field by the magnetized pattern is connected in series to an ordinary resistor element B staying out of influence of the magnetic field. Bias voltage V is applied to both terminals of the series connection and output voltage Vo is picked up at the junction between the magnetic and ordinary resistor elements. When the resistance of the magnetic resistor element A with no influence of the magnetic field is equal to RA, the resistance of the ordinary resistor element B is equal to RB and the time function of change in resistance of the magnetic resistor element A under influence of the magnetic field is equal to f(t), the instant resistance at time "t" of the magnetic resistor element is equal to $\{RA + f(t)\}$. Then the output voltage Vo is given by the following equation.

$$Vo = \frac{V\{RA+f(t)\}}{\{RA+f(t)+RB\} + RB} = \frac{V}{1 + \dfrac{2RB}{\{RA+f(t)\}}}$$

In the case of the above-described conventional magnetic resistor-type sensor, change in resistance of the magnetic resistor element causes corresponding change in current flowing through the circuit, thereby lowering the level of the output. In addition, temperature coefficient of the resistor elements greatly sway the DC component of the output causing difficulty in the later stage signal processing.

### Summary of the invention

It is the basic object of the present invention to remove any malign influence of the change in resistance of the magnetic resistor element on the current flowing through the circuit in order to keep high level of the output.

It is another object of the present invention to remove influence of the resistor element temperature coefficient on the DC component of the output in order to assure easy later stage signal processing.

In accordance to the basic aspect of the present invention, the first and second magnetic resistor elements are connected to each other in series in an arrangement such that their resistances should change with a phase-lag of 180° degrees under influence by periodical change of magnetic field applied to by a scale and should have a constant sum, the third and fourth resistor elements are connected in series to each other in an arrangement such that their resistances should always have a constant sum despite the periodical change of the magnetic field, each resistor element forms each side of a bridge circuit, resistances of the first to fourth resistor elements under no influence of the magnetic field are set to values which balance the bridge circuit, bias voltage is applied to between the junction of the first and third resistor elements and the junction of the second and fourth resistor elements and output voltage is picked up between the junction of the first and second resistor elements and the junction of the third and fourth resistor elements.

Brief description of the drawings

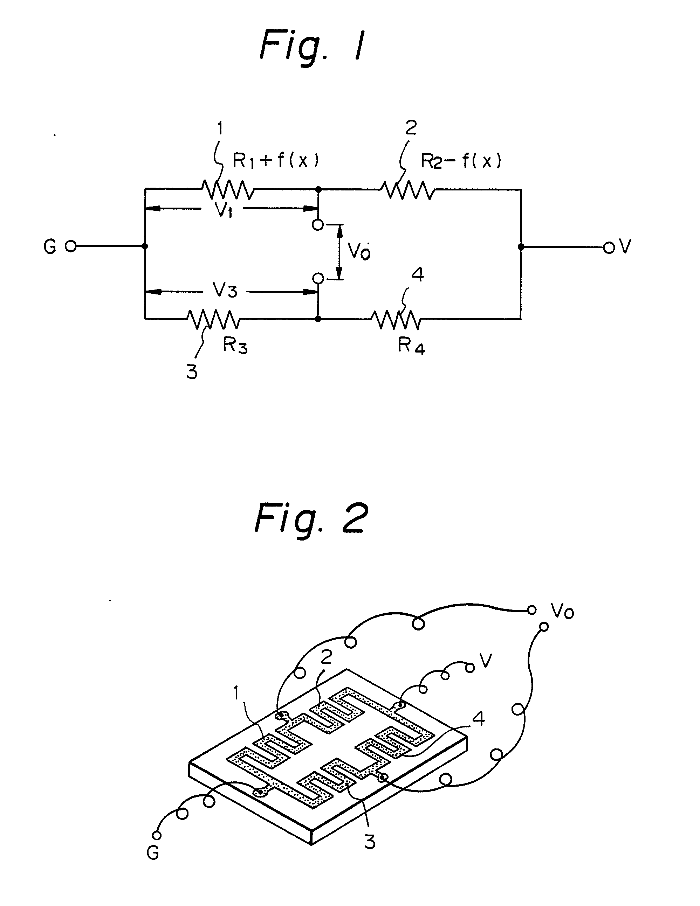

Figs. 1 and 2 are a circuit diagram and a perspective view of one embodiment of the magnetic resistor-type sensor in accordance with the present invention.

Description of the preferred embodiments.

As best seen in Fig.2, the magnetic resistor-type sensor includes the first and second magnetic resistor elements 1 and 2 which are connected in series to each other and change their resistances under influence of magnetic field applied to by a scale (not shown). The magnetic resistor elements 1 and 2 are arranged such that their resistances should change with a phaselag of 180 degrees under influence by periodical change of the magnetic field. When the resistance of the first magnetic resistor element 1 under no influence of the magnetic field is equal to $R_1$ and the time function change in resistance of the magnetic resistor elements 1 and 2 under influence of the magnetic field is equal to f(t), its instant resistance at time "t" is equal to $\{R_1 + f(t)\}$ . When the resistance of the second magnetic element 2 under no influence of the magnetic field is equal to $R_2$, its instant resistance at time "t" is equal to $\{R_2 - f(t)\}$ . As a consequence, the sum of the resistances is always equal to $(R_1 + R_2)$ without any relation to the influence of the magnetic field applied to by the scale whose displacement should be detected.

The magnetic resistor-type sensor further includes the third and fourth resistor elements 3 and 4 which are connected in series to each other and arranged such that their resistances should always have a constant sum despite the periodical change of the magnetic field. In the illustrated example, the resistor elements 3 and 4 are ordinary resistors having fixed resistances $R_3$ and $R_4$.

The first to fourth resistor elements 1 to 4 mounted to a common substrate, or a common place in an encoder, to form a bridge circuit. Under no influence of the magnetic field, they should balance the bridge circuit. In other words, the following relationship should be established between the resistor elements·1 to 4.
$$R_1 \bullet R_4 = R_2 \bullet R_3$$
In the bridge circuit of this construction, bias voltage V is applied to between the junction of the first and third resistor elements 1, 3 and the junction of the second and fourth resistor elements 2, 4. Output voltage Vo is picked up between the junction of the first and second resistor elements 1, 2 and the junction of the third and fourth resistor elements 3, 4. The output voltage Vo is given by the following equation.

$$V_O = V_1 - V_2$$
$$= V \frac{R_1 + f(t)}{R_1 + R_2} - V \frac{R_3}{R_3 + R_4}$$
$$= V \left\{ \frac{R_1}{R_1 + R_2} - \frac{R_3}{R_3 + R_4} \right\} + V \left\{ \frac{f(t)}{R_1 + R_2} \right\}$$

The DC component of the output voltage, i.e. the first term in the equation, is equal to zero due to the balance condition $R_1 \bullet R_4 = R_2 \bullet R_3$. Then, the output voltage Vo is finally given by the following equation.

$$V_O = V \left( \frac{f(t)}{R_1 + R_2} \right)$$

As a consequence, there is no DC drift by temperature and no later stage DC bias is needed. Constant current flows in the circuit and DC current drive is employable by use of a constant voltage source.

The resistor elements 1 to 4 exhibit same temperature, thereby keeping balance of the bridge circuit.

It is also possible to employ an equal resistance for all the resistor elements 1 to 4. In this case, the output voltage Vo is given by the following equation.

3

$$V_0 = V\frac{f(t)}{2R_2}$$

Resistance of the third and fourth resistor elements 3 and 4 can be set quite freely as long as they always have a constant sum and balance the bridge circuit under no influence of the magnetic field. For example, the third resistor element 3 may be same as the first magnetic resistor element 1 and the fourth resistor element 4 may be same as the second magnetic resistor element 2 so that all resistor elements 1 to 4 should be influenced by the periodical change of the magnetic field applied to by the scale.

**Claims**

1. An improved magnetic resistor-type sensor for encoders comprising
first and second magnetic resistor elements connected in series to each other in an arrangement such that their resistances should change with a phase-lag of 180 degrees under influence by periodical change of magnetic field applied to by a scale and should have a constant sum,
third and fourth resistor elements connected in series to each other in an arrangement such that their resistances should always have a constant sum despite said periodical change of said magnetic field, and
a bridge circuit having each side formed by each of said first to fourth resistor elements,
resistances of said first to fourth resistor elements under no influence of said magnetic field being set to values which balance said bridge circuit,
bias voltage being applied between a junction of said first and third resistor elements and a junction of said second and fourth resistor elements, and
output voltage being picked up between a junction of said first and second resistor elements and a junction between said third and fourth resistor elements.

2. An improved magnetic resistor-type sensor as claimed in claim 1 in which
said third and fourth resistor elements are ordinary resis tors having fixed resistances.

3. An improved magnetic resistor-type sensor as claimed in claim 1 in which
said third and fourth resistor elements are also magnetic resistor elements.

4. An improved magnetic resistor-type sensor as claimed in claim 1, 2 or 3 in which
said first to fourth resistor elements have equal resistances.

# Fig. 1

# Fig. 2